(19) **Europäisches Patentamt / European Patent Office / Office européen des brevets**

(11) **EP 1 939 313 A2**

(12) # EUROPEAN PATENT APPLICATION

(43) Date of publication:
**02.07.2008 Bulletin 2008/27**

(51) Int Cl.:
***C22C 29/08*** (2006.01)

(21) Application number: **07122490.1**

(22) Date of filing: **06.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **27.12.2006 SE 0602815**

(71) Applicant: **Sandvik Intellectual Property AB 81181 Sandviken (SE)**

(72) Inventors:
- **Åkesson, Leif
  125 51 Älvsjö (SE)**
- **Westergren, Kenneth
  129 35 Hägersten (SE)**

(74) Representative: **Hägglöf, Henrik
  Sandvik Intellectual Property AB
  811 81 Sandviken (SE)**

(54) **Coated cemented carbide insert particularly useful for heavy duty operations**

(57)    The present invention relates to coated cutting tool inserts particularly useful for heavy roughing turning operations of very large steel components, such as drive shafts for ships and shafts for wind power plants. The inserts are large with an iC, inscribed circle diameter, of $\geq$19 mm and a thickness of $\geq$6 mm with a composition of 5-10 wt-% Co, 5-12 wt-% cubic carbides or carbonitrides of the metals Ti, Ta and/or Nb, and balance WC with a stratified binder phase enriched surface zone 15-40 $\mu$m thick. The inserts have an edge rounding before coating of 35-95 $\mu$m. The coating comprises
- a first, innermost layer of $TiC_xN_yO_z$ and a total thickness 0.1-1.5 $\mu$m,
- a second layer of $TiC_xN_y$ with a thickness of 4.5-9.5 $\mu$m with columnar grains,
- a third layer of $TiC_xN_yO_z$ with a thickness of 0.3-1.5 $\mu$m,
- a fourth layer of a smooth $\alpha$-$Al_2O_3$ with a thickness of 4.5-9.5 $\mu$m and,
- a 0.1-2 $\mu$m thick coloured top layer, preferably TiN or ZrN, on the clearance sides.

The invention also relates to the method of making such inserts and the use thereof for heavy roughing turning operations of very large steel components.

**EP 1 939 313 A2**

**Description**

The present invention relates to coated cemented carbide inserts with a binder phase enriched surface zone particularly useful for heavy roughing turning operations of very large steel components with improved edge security and wear resistance in combination with extremely good plastic deformation resistance.

For turning of steel materials, both stainless and normal steels, coated cemented carbide inserts are widely used, especially CVD-coated inserts with a binder phase enriched cemented carbide body.

Through the binder phase enriched surface zone an extension of the application area is obtained. The far most commonly used type is a cemented carbide body with a 10-30 $\mu$m thick surface zone that is essentially free from cubic phase and moderately enriched in binder phase. Examples are US 4,277,283, US 4,610,931, US 4,830,283 and US 5,106,674.

Another type of binder phase enriched cemented carbide inserts is the so called stratified type, which is accomplished using a powder with very carefully controlled carbon content and a sintering process with controlled cooling. This type has a surface zone 15-45 $\mu$m thick, which is more strongly enriched in binder phase by several thin stratified layers of binder phase essentially parallel to the outer surface. In large scale production, the carbon control is difficult and the stratified binder phase enrichment is rarely used in practice.

EP-A-603143 discloses a cemented carbide with a binder phase enriched surface zone, said cemented carbide containing WC and cubic phases in a binder phase in which the binder phase enriched surface zone has an outer part essentially free of cubic phase and an inner part containing cubic phase and stratified binder phase layers. It is thus a combination of the abovementioned two types of binder phase enrichments.

Heavy duty machining operations to which the invention relates are characterized by the use of relatively high forces to shape workpieces both by non-cutting and cutting processes. Such operations include non-cutting shaping processes such as extruding, rolling, drawing and ironing and cutting processes such as punching, shearing, and broaching, as well as high force drilling, grinding, milling and turning processes. Characteristic of heavy duty machining operations, work done on the workpiece together with friction between the tool and workpiece generate sufficient heat to distort the workpiece and cause high rates of tool wear.

One example of a heavy duty application is heavy roughing turning operations of very large steel components such as drive shafts for ships and shafts for wind power plants which can be up to 20 m long and up to 1.5 m in diameter, where large cutting inserts are used with iC $\geq$19 mm, iC is the diameter of the inscribed circle of the insert, and a thickness of $\geq$6 mm. The demands on the cutting inserts are extremely high as the forged shafts often are oval and have forged skin and inclusions in the surface (oxide scale). With the ovality leads to that the depth of cut (DOC) may be zero occasionally during the cutting operation. The steel type may be low alloyed or carbon steel, e.g., tough hardened steel. Furthermore, the cutting data is extreme with feed rates up to 2.5 mm and depths of cut up to 30 mm. This together puts very high demands on toughness behaviour, resistance to plastic deformation and wear resistance on the cutting tool insert.

It is an object of the present invention to provide a cutting tool insert particularly useful for heavy duty applications such as heavy roughing turning operations of very large steel components.

It is a further object of the present invention to provide a cutting tool insert with improved edge security, wear resistance in combination with extremely good plastic deformation resistance.

It has now surprisingly been found that cutting tool inserts showing improved properties with respect to the different demands prevailing at the above mentioned cutting operations can be obtained with cutting tool inserts comprising: a cemented carbide body with a stratified binder phase enriched surface zone partly depleted in cubic phase and with a well balanced carbon content giving a well defined content of free carbon, graphite, in the inner part of the cemented carbide body, preferably in combination with a columnar $TiC_xN_y$-layer and a post treated $\alpha$-$Al_2O_3$ top layer.

According to the present invention a coated cutting tool insert is provided comprising a cemented carbide with a binder phase with a very low W-content and with a stratified binder phase enriched surface zone partly depleted in cubic phase and a coating preferably comprising a columnar $TiC_xN_y$-layer and a post treated $\alpha$-$Al_2O_3$ top layer. The inserts are large with an iC of $\geq$19 mm, preferably 30-60 mm and a thickness of $\geq$6 mm, preferably 9-20 mm.

The cemented carbide has a composition of 5-10, preferably 5.5-8, most preferably 6-7 wt-% Co, 5-12, preferably 7-10, most preferably 8-9 wt-% cubic carbides or carbonitrides of the metals from group IVA and VA, preferably Ti, Ta and Nb, and preferably with a Ti-content of 1.0-4.0 wt-%, most preferably 1.5-3.0 wt-%, and balance WC, preferably 80-88 wt-% WC. The nitrogen content is <0.1, preferably 0.02-0.1, most preferably 0.04-0.07, wt-% and the carbon content is adjusted to correspond to a C-porosity in the inner central part of the cemented carbide body of C06-C08, preferably C08. The stratified binder phase enriched surface zone is 15-45, preferably 20-40, most preferably 25-35, $\mu$m thick, preferably with an outer part essentially free from cubic phase. The thickness of this outer part is 25-50, preferably 30-45, % of the total thickness of the stratified binder phase enriched surface zone. The binder phase content of the binder phase enriched surface zone has a maximum of 1.5-4, preferably 2-3, times the nominal binder phase content. Further, the stratified binder phase enriched surface zone as well as an about 100-300 $\mu$m thick zone underneath

it contain no free graphite, i.e., corresponds to a C-porosity of C00. The Hc-value is 9-13.5, preferably 10-12, kA/m.

The cobalt binder phase is alloyed to a very low amount of tungsten (W). W in the binder phase influences the magnetic properties of cobalt and can hence be related to a value, CW-ratio, defined as

$$CW\text{-}ratio = magnetic\text{-}\% \ Co \ / \ wt\text{-}\% \ Co$$

where magnetic-% Co is the weight percentage of magnetic Co and wt-% Co is the weight percentage of Co in the cemented carbide.

The CW-ratio can vary between 1 and about 0.75 dependent on the degree of alloying. A lower CW-ratio corresponds to a higher W content and CW-ratio =1 corresponds practically to an absence of W in the binder phase.

According to the present invention the improved cutting performance is enhanced if

A) the cemented carbide has a CW-ratio of 0.96-1.0, preferably within 0.98-1.0, most preferably within 0.99-1.0
B) the cutting inserts have an edge rounding before coating of 35-95, preferably 40-60, $\mu$m.
C) the coating comprises:

- a first, innermost layer of $TiC_xN_yO_z$ with x+y+z=1, y>x and z<0.2, preferably y>0.8 and z=0 and a total thickness 0.1-1.5 $\mu$m, preferably >0.4 $\mu$m.
- a second layer of $TIC_xN_y$ with x+y=1, x>0.3 and y>0.3, with a thickness of 4.5-9.5 $\mu$m, preferably 5-7.5 $\mu$m, with columnar grains.
- a third layer of $TiC_xN_yO_z$ with x+y+z=1, x>0.3 and z>0.3, 0<=y<0.2, with a thickness of 0.3-1.5 $\mu$m.
- a fourth layer of a smooth $\alpha$-$Al_2O_3$ with a thickness of 4.5-9.5 $\mu$m, preferably 5-7.5 $\mu$m and a surface roughness in the cutting area zone of Ra<0.4 $\mu$m over a length of 10 $\mu$m.
- the ratio of layer thicknesses of the fourth layer of $Al_2O_3$ and the second layer of $TiC_xN_y$ is preferably 0.8-1.2.
- a 0.1-2 $\mu$m thick coloured top layer, preferably TiN or ZrN on the clearance side.

The present invention also relates to a method of making coated cutting tool inserts with a cemented carbide body with a composition of 5-10, preferably 5.5-8, most preferably 6-7 wt-% Co, 6-11, preferably 7-10, most preferably 8-9 wt-% cubic carbides or carbonitrides of the metals from group IV and V, preferably Ti, Ta and Nb, and preferably with a Ti-content of 1-4 wt-%, most preferably 1.5-3 wt-%, and balance WC, preferably 80-88 wt-% WC. The nitrogen content is <0.1, preferably 0.02-0.10, most preferably 0.04-0.07, wt-% and the carbon content is adjusted to correspond to a C-porosity in the inner central part of the cemented carbide body of C06-C08, preferably C08.

Production of cemented carbides according to the invention is most favourably done by sintering a presintered or compacted body containing nitrogen and for formation of stratified layers, an optimum amount of carbon in an inert atmosphere or in vacuum, 15 to 180 min at 1380-1520°C, followed by slow cooling, 20-100°C/h, preferably 40-70°C/h, through the solidification region, 1300-1220°C, preferably 1290-1240°C. The sintering conditions are adjusted to obtain an Hc-value in the range of 9-13.5, preferably 10-12, kA/m. The CW-ratio should be 0.96-1, preferably within 0.98-1, most preferably within 0.99-1. The stratified binder phase enriched surface zone is 15-45, preferably 20-40, most preferably 25-35 $\mu$m thick preferably with an outer part essentially free from cubic phase. The thickness of this outer part is 25-50, preferably 30-45, % of the total thickness of the stratified binder phase enriched surface zone. The binder phase content of the binder phase enriched surface zone has a maximum of 1.5-4, preferably 2-3, times the nominal binder phase content. Prior to the coating the inserts are treated to an edge radius of 35-95, preferably 40-60, $\mu$m and surface cleaned using electrochemical or blasting methods.

The inserts are provided with a coating comprising

- a first, innermost layer of $TiC_xN_yO_z$ with x+y+z=1, y>x and z<0.2, preferably y>0.8 and z=0 and a total thickness 0.1-1.5 $\mu$m, preferably >0.4 $\mu$m using known CVD-methods.
- a second layer of $TiC_xN_y$ with x+y=1, x>0.3 and y>0.3, with a thickness of 4.5-9.5 $\mu$m, preferably 5-7.5 $\mu$m, with columnar grains using the MTCVD-technique with acetonitrile as the carbon and nitrogen source for forming the layer in the temperature range of 700-900 °C. The exact conditions, however, depend to a certain extent on the design of the equipment used,
- a third layer of $TiC_xN_yO_z$ with x+y+z=1, x>0.3 and z>0.3, 0<=y<0.2, with a thickness of 0.3-1.5 $\mu$m using known CVD-methods,
- a fourth layer of a smooth $\alpha$,-$Al_2O_3$ with a thickness of 4.5-9.5 $\mu$m, preferably 5-7.5 $\mu$m using known CVD-methods. Preferably, the ratio of layer thicknesses of the fourth layer of $Al_2O_3$ and the second layer of $TiC_xN_y$ is 0.8-1.2,
- a 0.1-2 $\mu$m thick coloured top layer, preferably TiN or ZrN. The top layer is present on the clearance side and is removed on the rake face by brushing or blasting to a surface roughness in the cutting area zone of Ra<0.4 $\mu$m over a length of 10 $\mu$m.

The present invention also relates to the use of cutting tool inserts as described above for heavy duty machining applications such as heavy roughing turning operations of very large components of steel, preferably of carbon steel or low alloyed steel, e.g., tough hardened steel, such as drive shafts for ships and shafts for wind power plants which can be as large as 20 m long and up to 1.5 m in diameter using large cutting inserts with an iC of ≥ 19 mm, preferably 30-60 mm and a thickness of ≥6 mm, preferably 9-20 mm at a cutting speed of in the range of 25-100, preferably 25-75 m/min, feed rates in the range of 1-2.5 mm and depth of cut from 0 to 30 mm, depth of cut = 0 due the the ovality of the work pieces, preferably 3-30 mm.

Example 1

From a powder mixture with the composition 2.2 weight-% TiC, 0.5 weight-% TiCN, giving an N-content of 0.05 wt-%, 3.6 weight-% TaC, 2.4 weight-% NbC, 6.5 weight-% Co and rest WC with 0.25 weight-% overstoichiometric carbon content, turning inserts SCMT380932 with iC=38 mm and thickness=9.5 mm were pressed. The inserts were sintered in $H_2$ up to 450°C for dewaxing and further in vacuum to 1350°C and subsequently in a protective atmosphere of 40 mbar Ar for 1 h at 1450°C. The cooling was performed with a well controlled temperature decrease of 60°C/h within the temperature interval 1290 to 1240°C in the same protective atmosphere. After that the cooling continued as normal furnace cooling with maintained protective atmosphere.

The sintered inserts had a binder phase enriched surface zone. The outer part of this surface zone was moderately binder phase enriched, essentially free of cubic phase and with a weakly developed statified binder phase structure, and had a thickness of 15 $\mu$m. Inside this outer part, there was a 20 $\mu$m thick zone containing cubic phase and with a strong cobalt enrichment as a stratified binder phase structure. The maximum cobalt-content in this part was 17 weight-% as an average over a distance of 100 $\mu$m parallel to the surface. The measurement was done using line scan in a micro-probe analyser equipped with wavelength dispersive spectrometer (WDS). Further below this part there was a zone about 150-200 $\mu$m thick with essentially nominal content of cubic phase and binder phase but without graphite. In the inner part of the insert graphite was present corresponding to a C-porosity of C08. The Hc-value was 11.5 and the CW-ratio was 0.99.

The inserts were edge rounded using a brushing method to a radius of 50 $\mu$m and surface cleaned by an electrochemical method and then coated with a first 0.5 $\mu$m thick $TiC_xN_y$-layer with a high nitrogen content corresponding to an x-value of about 0.05, followed by a second 8 $\mu$m thick $TiC_xN_y$-layer, with an x-value of about 0.55 and with a columnar grain structure using MTCVD-technique (temperature 850-885 °C and $CH_3CN$ as the carbon/nitrogen source). In subsequent steps during the same coating cycle a third 1 $\mu$m thick Ti(C,O)-layer was deposited followed by a fourth 7 $\mu$m thick layer of $\alpha$-$Al_2O_3$ and a 1 $\mu$m thick top layer of TiN.

The inserts were finally wet blasted on the rake face with alumina grit in order to remove the top TiN-layer and to produce a smooth surface finish of the exposed $Al_2O_3$-layer of Ra=0.2 $\mu$m over a length of 10 $\mu$m.

Example 2

Inserts from Example 1 were tested at a customer producing shafts for wind power plants and compared to commercially available inserts suitable for this type of operation and in the same insert style as in Example 1, see table 1 (prior art).

Table 1

| Variant | Substrate composition, wt-% #) | | | | Surface zone *) | | Coating thickness, $\mu$m and type | |
|---------|------|------|------|------|------|------|------|------|
| | Co | TaC | NbC | TiC | $\mu$m | CW-ratio | | |
| Ref A | 7.5 | 2.9 | 0.5 | 2.3 | 26 | 0.88 | 8.0 $TiC_xN_y$, | 7.0 $\alpha$-$Al_2O_3$ |
| Ref B | 10.0 | 5.6 | - | 2.9 | 20 | 0.82 | 6.5 $TiC_xN_{y, x-0.55, y=0.45}$ | 5.0 K-$Al_2O_3$ |
| #) rest WC | | | | | | | | |
| *) binder phase enriched free from cubic phase, non-stratified | | | | | | | | |

The inserts were tested in a heavy roughing longitudinal turning operation of a forged shaft with diameter 800 mm and 8 m in length in steel SS2244.
Cutting data:

Cutting speed: 37 m/min
Feed rate: 1.8 mm/rev
Depth of cut: 4-30 mm (sometimes 0, due to ovality)
No coolant

The tool life of the insert according to invention (Example 1) was 115 min compared to 55 min and 38 min for ref A and ref B, respectively. The wear type was mainly flank wear for the insert according to the invention, plastic deformation and breakage for ref A, and plastic deformation for ref B.
From Example 2 it is evident that the insert according to the invention gives superior performance due a very good combination of edge toughness and plastic deformation resistance.

**Claims**

1. Coated cutting tool insert comprising a cemented carbide insert body with stratified binder phase enriched surface zone and a coating **characterised in that**

   - the stratified binder phase enriched surface zone has a binder phase content having a maximum of 1.5-4, preferably 2-3, times the nominal binder phase content and is 15-45, preferably 20-40, most preferably 25-35, $\mu$m thick whereby the stratified binder phase enriched surface zone as well as an about 100-300 $\mu$m thick zone underneath it contain no free graphite, i.e., correspond to a C-porosity of C00 and with a C-porosity in the inner central part of the cemented carbide body of C06-C08, preferably C08, and
   - the inserts are large with an iC, inscribed circle diameter, of $\geq$19 mm, preferably 30-60 mm and a thickness of $\geq$6 mm, preferably 9-20 mm.

2. Coated cutting tool insert according to claim 1 **characterised in that** the stratified binder phase enriched surface zone has an outer part essentially free from cubic carbide phase with a thickness of 25-50, preferably 30-45, % of the total thickness of the binder phase enriched surface zone and the nitrogen content is 0.02-0.10, preferably 0.04-0.07, wt-%.

3. Coated cutting tool insert according to any of the preceding claims **characterised in that** the cemented carbide has a CW-ratio of 0.96-1.0, preferably 0.98-1.0, most preferably 0.99-1.0.

4. Coated cutting tool insert according to any of the preceding claims **characterised in that**

   - the cemented carbide has a composition of 5-10, preferably 5.5-8, most preferably 6.0-7.0 wt-% Co, 5-12, preferably 7-10, most preferably 8-9 wt-% cubic carbides or carbonitrides of the metals from groups IVb and Vb, preferably Ti, Ta and/or Nb, and preferably with a Ti-content of 1.0-4.0 wt-%, most preferably 1.5-3.0 wt-%, and balance WC, preferably 80-88 wt-% WC, whereby the nitrogen content is <0.10,
   - the cemented carbide has an Hc-value of 9-13.5, preferably 10-12, kA/m and
   - an edge rounding of 35-95, preferably 40-60, $\mu$m.

5. Coated cutting tool insert according to any of the preceding claims **characterised in that** the coating comprises

   - a first, innermost layer of $TiC_xN_yO_z$ with x+y+z=1, y>x and z<0.2, preferably y>0.8 and z=0 and a total thickness 0.1-1.5 $\mu$m, preferably >0.4 $\mu$m,
   - a second layer of $TiC_xN_y$ with x+y=1, x>0.3 and y>0.3, with a thickness of 4.5-9.5 $\mu$m, preferably 5-7.5 $\mu$m, with columnar grains,
   - a third layer of $TiC_xNyO_z$ with x+y+z=1, x>0.3 and z>0.3, 0<=y<0.2, with a thickness of 0.3-1.5 $\mu$m,
   - a fourth layer of a smooth $\alpha$-$Al_2O_3$ with a thickness of 4.5-9.5 $\mu$m, preferably 5-7.5 $\mu$m and a surface roughness in the cutting area zone of Ra<0.4 $\mu$m over a length of 10 $\mu$m,
   - the ratio of layer thicknesses of the fourth layer of $Al_2O_3$ and the second layer of $TiC_xN_y$ is preferably 0.8-1.2 and
   - a 0.1-2 $\mu$m thick coloured top layer, preferably TiN or ZrN, on the clearance sides.

6. Method of making a coated cutting tool insert comprising a cemented carbide insert body with stratified binder phase enriched surface zone and a coating **characterised in** providing a cemented carbide insert body with an inscribed circle diameter of $\geq$ 19 mm, preferably 30-60 mm, and a thickness of $\geq$ 6 mm, preferably 9-20 mm, with a carbon content to correspond to a C-porosity in the inner central part of the cemented carbide insert body of C06-C08, preferably C08 and a Hc-value of 9.0-13.5, preferably 10.0-12.0 kA/m and that the stratified binder phase enriched surface zone is 15-45, preferably 20-40, most preferably 25-35 μm thick and the binder phase content of the binder phase enriched surface zone has a maximum of 1.5-4, preferably 2-3, times the nominal binder phase content made by sintering a presintered or compacted body with for formation of stratified layers optimum amount of carbon in an inert atmosphere or in vacuum, 15 to 180 min at 1380-1520°C, followed by slow cooling, 20-100°C/h, preferably 40-70°C/h, through the solidification region, 1300-1220°C, preferably 1290-1240°C.

7. Method according to claim 6 **characterised in that** the cemented carbide has a composition of 5-10, preferably 5.5-8, most preferably 6.0-7.0 wt-% Co, 5-12, preferably 7-10, most preferably 8-9 wt-% cubic carbides or carbonitrides of the metals from group IV and V, preferably Ti, Ta and/or Nb, and preferably with a Ti-content of 1.0-4.0 wt-%, most preferably 1.5-3.0 wt-%, and balance WC, preferably 80-88 wt-% WC with a nitrogen content of 0.02-0.10, preferably 0.04-0.07 wt-%.

8. Method according to any of claims 6 or 7 **characterised in that** the cemented carbide has a CW-ratio of 0.96-1.0, preferably 0.98-1.0, most preferably within 0.99-1.0,

9. Method according to any of claims 6, 7 or 8 **characterised in**

- edge rounding the inserts to a radius of 35-95, preferably 40-60, μm and cleaning the surface using electrochemical or blasting methods,
- depositing a coating comprising
- a first, innermost layer of $TiC_xN_yO_z$ with x+y+z=1, y>x and z<0.2, preferably y>0.8 and z=0 and a total thickness 0.1-1.5 μm, preferably >0.4 μm using known CVD-methods,
- a second layer of $TiC_xN_y$ with x+y=1, x>0.3 and y>0.3, with a thickness of 4.5-9.5 μm, preferably 5-7.5 μm, with columnar grains using the MTCVD-technique with acetonitrile as the carbon and nitrogen source for forming the layer in the temperature range of 700-900 °C,
- a third layer of $TiC_xN_yO_z$ with x+y+z=1, x>0.3 and z>0.3, 0<=y<0.2, with a thickness of 0.3-1.5 μm using known CVD-methods,
- a fourth layer of a smooth $α-Al_2O_3$ with a thickness of 4.5-9.5 μm, preferably 5-7.5 μm using known CVD-methods, preferably such that the ratio of layer thicknesses of the fourth layer of $Al_2O_3$ and the second layer of $TiC_xN_y$ being 0.8-1.2,
- a 0.1-2 μm thick coloured top layer, preferably TiN or ZrN using known CVD-methods, and
- removing the top layer on the rake face by brushing or blasting to a surface roughness in the cutting area zone of Ra<0.4 μm over a length of 10 μm.

10. Use of cutting tool inserts according to above for heavy duty machining applications such as heavy roughing turning operations of very large components of steel, preferably carbon steel or low alloyed steel, e.g. tough hardened steel, such as drive shafts for ships and shafts for wind power plants which can be as large as 20 m long and up to 1.5 m in diameter using large cutting inserts with an iC of ≥19 mm, preferably 30-60 mm and a thickness of ≥6 mm, preferably 9-20 mm at a cutting speed of in the range of 25-100, preferably 25-75 m/min, feed rates in the range of 1-2.5 mm and depth of cut from 0 to 30 mm, depth of cut=0 due the ovality of the work pieces, preferably 3-30 mm.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4277283 A
- US 4610931 A
- US 4830283 A
- US 5106674 A
- EP 603143 A